# EUROPEAN PATENT SPECIFICATION

(11) **EP 1 320 881 B1**
(45) Date of publication and mention of the grant of the patent: **16.12.2009**
(21) Application number: 01958750.0
(22) Date of filing: 07.08.2001
(51) Int. Cl.: H01L 21/60, H01L 21/54, H01L 23/31, H01L 23/48

(54) **METHOD OF SECURING SOLDER BALLS AND ANY COMPONENTS FIXED TO ONE AND THE SAME SIDE OF A SUBSTRATE**
VERFAHREN ZUM BEFESTIGEN VON LOTKUGELN UND ETWAIGEN BAUELEMENTEN, DIE AN EIN UND DERSELBEN SEITE EINES SUBSTRATS ANGEBRACHT SIND
PROCEDE DE MAINTIEN DE GLOBULES DE SOUDURE ET DE TOUT COMPOSANT MIS EN PLACE SUR LE MEME ET UNIQUE COTE D'UN SUBSTRAT

(30) Priority: 08.08.2000 SE 0002850
(43) Date of publication of application: 25.06.2003
(73) Proprietor: TELEFONAKTIEBOLAGET LM ERICSSON (publ), 164 83 Stockholm (SE)
(72) Inventor: OLOFSSON, Lars-Anders, S-175 43 Järfälla (SE); JONAS, Ivan, S-184 32 kersberga (SE)
(74) Representative: Bratt, Hanna Catharina
(86) International application number: PCT/SE2001/001718
(87) International publication number: WO 2002/013256

(56) References cited:
- WO-A1-99/00835
- US-A- 5 554 887
- US-A- 5 895 229
- US-A- 5 984 164
- US-A- 6 038 136

## Description

### TECHNICAL FIELD

The invention relates to safely securing solder balls and any discrete components fixed to one and the same side of substrates.

### BACKGROUND OF THE INVENTION

In operation, solder balls on ball grid array (BGA) modules as well as solder bumps on dies and on substrates in chip scale packages (CSPs) are all exposed to thermomechanical stress. So are also any discrete components mounted on the same side as the solder balls or solder bumps. Moreover, these discrete components will also be exposed to moisture, contamination, aggressive substances, compression, shocks etc.

After that e.g. a BGA module is mounted on a substrate by soldering the solder balls to bonding pads on the substrate, it is known to fill the gap between the BGA module and the substrate with an underfill material to protect the solder balls and any discrete components mounted on the same side of the BGA module as the solder balls.

Besides the fact that filling such gaps with an underfill material is time-consuming, and consequently expensive, such an underfill material can affect the electric properties of the discrete components on the BGA module since the dielectric constant is changed around these components.

### SUMMARY OF THE INVENTION

The object of the invention is to bring about protection of the solder balls and any discrete components mounted on the same side of a substrate as the solder balls and at the same time improve both the solderability of the solder balls and their reliability what concerns thermomechanical stress.

This is attained by covering the discrete components with a layer of a molding compound and by flattening the solder balls and surrounding them partly by that molding compound.

Hereby, a mechanically more stable unit as such is obtained at the same time as its solderability is improved.

### BRIEF DESCRIPTION OF THE DRAWING

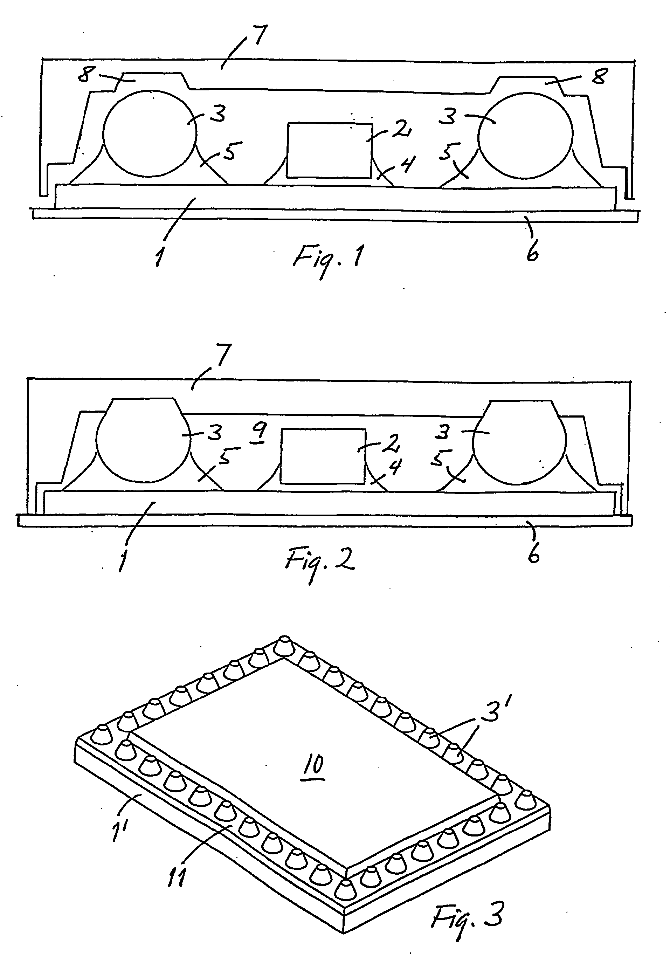

The invention will be described more in detail below with reference to the appended drawing on which Fig. 1 is a cross-sectional view of an embodiment of an transfer molding tool according to the invention in its open position with a BGA module to be transfer molded in accordance with the invention, Fig. 2 illustrates the transfer molding tool of Fig. 1 in its closed position, and Fig. 3 is a perspective view of an embodiment of a BGA module according to the invention.

### DESCRIPTION OF THE INVENTION

Fig. 1 is a cross-sectional view of a BGA module comprising a substrate 1 shown with only one discrete component 2 and two solder balls 3 fixed to the substrate 1 by means of e.g. solder joints 4 and 5, respectively.

It is to be understood that, normally, there are more than one discrete component fixed to the substrate 1 and a number of solder balls 3 along all four edges of the substrate 1. However, it is to be understood that the invention is applicable also to the case when there are just solder balls and no discrete components fixed to the substrate.

The diameter of the solder balls 3 is larger than the height of any discrete component 2.

In Fig. 1, the substrate 1 with the component 2 and the solder balls 3 is located in an embodiment of an opened transfer molding tool according to the invention, comprising a lower stationary part 6, and an upper movable part 7 to be pressed towards to the stationary part 6.

It is to be understood that, equally well, the lower part can be movable and the upper part can be stationary.

In the embodiment in Fig. 1, the substrate 1 rests on the stationary part 6 with the component 2 and the solder balls 3 facing upwards towards the movable part 7.

In accordance with the invention, on its side facing the component 2 and the solder balls 3, the movable part 7 of the transfer molding tool is provided with a flat-bottomed cavity 8 for each solder ball 3. Each cavity 8 can have the shape of e.g. a truncated cone.

When the molding tool is compressed, i.e. the movable part 7 is pressed against the stationary part 6, each solder ball 3 is received in its corresponding cavity 8. By the compressing force exercised by the movable part 7, the top portion of the solder balls 3 fills out the respective cavity 8 to be formed accordingly, whereby the top portion of the solder balls 3 is flattened by the flat bottom of the cavities 8. Hereby, the solderability of the solder balls is improved.

It is to be understood that, equally well, the flat-bottomed cavities for receiving the solder balls can be provided on the lower part of the molding tool.

Fig. 2 illustrates the position in which the movable part 7 of the transfer molding tool is fully compressed with the stationary part 6. As apparent from Fig. 2, the top portion of the solder balls 3 fills out the respective cavity 8 and is flattened.

A gap 9 is formed between the stationary part 6 and the movable part 7 of the transfer molding tool. This gap 9 extends around the solder balls 3.

In accordance with the invention, a transfer molding compound, i.e. a thermosetting compound, is supplied to the gap 9 between the stationary part 6 and the movable part 7 of the transfer molding tool. This compound fills the gap 9 and forms a layer that covers the component 2 and surrounds the solder balls 3.

This layer of thermosetting compound will enable the substrate 1 with the component 2 and the solder balls 3 to better withstand thermomechanical stress. Also, the layer of thermosetting compound will make the substrate 1 with the component 2 and the solder balls 3 more robust. The flattened solder balls 3 will very much improve the solderability of the solder balls 3 of the BGA module to bonding pads on e.g. a printed circuit board.

Instead of transfer molding using a thermosetting compound, injection molding using a thermoplastic compound can be used.

It is to be understood that the height of the layer of molding thermosetting or thermoplastic compound does not have to be uniform throughout the gap 9 between the stationary part 6 and the movable part 7 of the transfer molding tool. Instead, the movable part 7 of the transfer molding tool can be designed such that the layer of thermosetting compound that surrounds the solder balls 3 will be lower than the layer of thermosetting compound that covers the components 2. Hereby, the performance of the solder balls what concerns thermomechanical stress improves even more.

Fig. 3 is a perspective view of such an embodiment of a BGA module. A substrate 1' is provided with a number of cone-shaped solder balls 3' along its edges. The not-shown components, if any, are covered by a layer 10 of thermosetting compound and the solder balls 3' are surrounded by a layer 11 of thermosetting compound that is lower than the layer 10.

As should be apparent from the above, the semiconductor component or module according to the invention will better withstand thermomechanical stress and is more robust than similar components and module known so far. At the same time, the solderability of the component or module is improved.

## Claims

1. A method of securing solder balls (3) and any components (2) fixed to one and the same side of a substrate (1), the components (2), if any, having a height that is less than the diameter of the solder balls (3), **characterized by**
- placing the substrate (1) in a compressible molding tool having flat-bottomed cavities (8) for individually receiving a top portion of each solder ball (3),
- compressing the molding tool to form the top portion of the solder balls (3) received in said cavities (8) to have a flat top, and
- supplying a molding compound into the molding tool to mold said compound to cover any components and surround at least a part of each solder ball.

2. The method according to claim 1, **characterized by** forming the solder balls into truncated cones.

3. A semiconductor component comprising discrete components (2) and solder balls (3) fixed to one and the same side of the semiconductor component, **characterized in that** the solder balls (3) are formed to have a flattened top, and that a molding compound (10, 11) covers the discrete components (2) and surrounds the solder balls (3).

4. The component according to claim 3, **characterized in that** the solder balls (3) are formed into truncated cones (3').

5. The component according to claim 3 or 4, **characterized in that** the molding compound (11) surrounding the solder balls (3') is lower than the molding compound (10) covering any discrete components (2).

6. A molding tool comprising two parts (6, 7) to be pressed together for molding a molding compound on a substrate having discrete components (2) and solder balls (3) on one and the same side, the discrete components (2) having a height that is less than the diameter of the solder balls (3), **characterized in that** one part (6) is adapted to receive the substrate with the components (2) and the solder balls (3) facing the other part (7), and that said other part (7) comprises flat-bottomed cavities (8) for individually receiving a top portion of each solder ball (3) and for forming the top portion of each solder ball (3) to have a flat top when the parts (6, 7) are pressed together.

7. The tool according to claim 6, **characterized in that** the cavities (8) are cone shaped.

## Patentansprüche

1. Verfahren zum Sichern von Lotkugeln (3) und jeglichen Bauelementen (2), die auf ein und derselben Seite eines Trägermaterials (1) befestigt sind, wobei die Komponenten (2), falls vorhanden, eine Höhe aufweisen, die kleiner ist als der Durchmesser der Lotkugeln (3),
**gekennzeichnet durch**
- Platzieren des Trägermaterials (1) in einem zusammenpressbaren Formwerkzeug mit Aussparungen (8) mit ebenen Böden zum einzelnen Aufnehmen eines oberen Bereichs jeder Lotkugel (3),
- Zusammenpressen des Formwerkzeuges, um den in den Aussparungen (8) aufgenommenen oberen Bereich der Lotkugeln (3) so zu formen, dass er eine flache Oberseite aufweist, und
- Zuführen einer Vergussmasse in das Formwerkzeug, um die Masse derart zu formen, dass sie jegliche Bauelemente bedeckt und zumindest einen Bereich jeder Lotkugel umgibt.

2. Verfahren nach Anspruch 1, **dadurch gekennzeichnet, dass** die Lotkugeln (3) zu Kegelstümpfe geformt werden.

3. Halbleiterbauelement mit diskreten Bauelementen (2) und Lotkugeln (3), die auf ein und derselben Seite des Halbleiterbauelements befestigt sind,
**dadurch gekennzeichnet, dass**
die Lotkugeln (3) so geformt sind, dass sie eine abgeflachte Oberseite haben, und dass eine Vergussmasse (10, 11) die diskreten Bauelemente (2) bedeckt und die Lotkugeln (3) umgibt.

4. Bauelement nach Anspruch 3, **dadurch gekennzeichnet, dass** die Lotkugeln (3) zu Kegelstümpfen (3') geformt sind.

5. Bauelement nach Anspruch 3 oder 4, **dadurch gekennzeichnet, dass** die Vergussmasse (11), die die Lotkugeln (3') umgibt, niedriger ist als die Vergussmasse (10), die jegliche diskrete Bauelemente (2) bedeckt.

6. Formwerkzeug mit zwei Teilen (6, 7) zum Zusammenpressen für das Vergießen einer Vergussmasse auf ein Trägermaterial, das diskrete Bauelemente (2) und Lotkugeln (3) auf ein und derselben Seite aufweist, wobei die diskreten Bauelemente (2) eine Höhe aufweisen, die kleiner ist als der Durchmesser der Lotkugeln (3), **dadurch gekennzeichnet, dass**
ein Teil (6) angepasst ist, das Trägermaterial mit den Bauelementen (2) und den Lotkugeln (3) derart aufzunehmen, dass sie dem anderen Teil (7) gegenüberliegen, und dass das andere Teil (7) Aussparungen (8) mit ebenen Böden zum einzelnen Aufnehmen eines oberen Bereichs jeder Lotkugel (3) und, wenn die Teile (6,7) zusammengepresst sind, zum Abflachen der Oberseite des oberen Breichs jeder Lotkugel (3) aufweist.

7. Werkzeug nach Anspruch 6, **dadurch gekennzeichnet, dass** die Aussparungen (8) kegelstumpfförmig sind.

## Revendications

1. Procédé de mise en place de billes de soudure (3) et d'éventuels composants (2) fixés à un seul et même côté d'un substrat (1), les composants (2), s'il y en a, ayant une hauteur qui est inférieure au diamètre des billes de soudure (3), **caractérisé par** :
- le positionnement du substrat (1) dans un outil de moulage compressible ayant des cavités à fond plat (8) destinées à recevoir individuellement une partie supérieure de chaque bille de soudure (3),
- la compression de l'outil de moulage pour façonner la partie supérieure des billes de soudure (3) reçues dans lesdites cavités (8) afin qu'elles aient une partie supérieure plane, et
- l'apport d'un composé de moulage dans l'outil de moulage pour mouler ledit composé afin de recouvrir les éventuels composants et d'entourer au moins une partie de chaque bille de soudure.

2. Procédé selon la revendication 1, **caractérisé par** le façonnage des billes de soudure sous forme de cônes tronqués.

3. Composant à semiconducteur comprenant des composants discrets (2) et des billes de soudure (3) fixées à un seul et même côté du composant à semiconducteur, **caractérisé en ce que** les billes de soudure (3) sont façonnées de façon à avoir une partie supérieure aplatie, et **en ce qu'**un composé de moulage (10, 11) recouvre les composants discrets (2) et entoure les billes de soudure (3).

4. Composant selon la revendication 3, **caractérisé en ce que** les billes de soudure (3) sont façonnées sous forme de cônes tronqués (3').

5. Composant selon la revendication 3 ou 4, **caractérisé en ce que** le composé de moulage (11) entourant les billes de soudure (3') est plus bas que le composé de moulage (10) recouvrant les éventuels composants discrets (2).

6. Outil de moulage comprenant deux parties (6, 7) devant être comprimées l'une contre l'autre pour mouler un composé de moulage sur un substrat ayant des composants discrets (2) et des billes de soudure (3) sur un seul et même côté, les composants discrets (2) ayant une hauteur qui est inférieure au diamètre des billes de soudure (3), **caractérisé en ce qu'**une partie (6) est apte à recevoir le substrat, les composants (2) et les bille de soudure (3) étant en face de l'autre partie (7), et **en ce que** ladite autre partie (7) comprend des cavités à fond plat (8) destinées à recevoir individuellement une partie supérieure de chaque bille de soudure (3) et à façonner la partie supérieure de chaque bille de soudure (3) afin qu'elle ait une partie supérieure plane lorsque les parties (6, 7) sont comprimées l'une contre l'autre.

7. Outil selon la revendication 6, **caractérisé en ce que** les cavités (8) ont une forme conique.
